# EUROPEAN PATENT SPECIFICATION

(11) **EP 3 830 098 B1**
(45) Date of publication and mention of the grant of the patent: **28.06.2023**
(21) Application number: 19742244.7
(22) Date of filing: 26.07.2019
(51) Int. Cl.: C07F 15/06, H01L 21/205, C23C 16/18

(54) **ORGANOMETALLIC COMPOUNDS**
ORGANOMETALLISCHE VERBINDUNGEN
COMPOSÉS MÉTAL-ORGANIQUES

(30) Priority: 27.07.2018 EP 18186140; 07.11.2018 DE 102018127836
(43) Date of publication of application: 09.06.2021
(73) Proprietor: UMICORE AG & Co. KG, 63457 Hanau-Wolfgang (DE)
(72) Inventor: SCHORN, Wolf, 76337 Waldbronn (DE); FREY, Annika, 63457 Hanau (DE); WÖRNER, Eileen, 61130 Nidderau (DE); DOPPIU, Angelino, 63500 Seligenstadt (DE); KARCH, Ralf, 63801 Kleinostheim (DE)
(74) Representative: Clauswitz, Kai-Uwe Wolfram
(86) International application number: PCT/EP2019/070208
(87) International publication number: WO 2020/021080

(56) References cited:
- KR-A- 20150 078 776
- N CHATANI ET AL.: "A New Entry to Pi-Allylcobalt Tricarbonyls Using (CH3)3SiCo(CO)4", TETRAHEDRON LETTERS, vol. 24, no. 50, 1 October 1983 (1983-10-01), pages 5649-5652, XP002787800,

## Description

Allyl-cobalt complexes having the general formula [Co(η³-C₃H₄-R1)(CO)₃] or [Co(η³-allyl-R1)(CO)₃], in particular [Co(η³-C₃H₅)(CO)₃] and methods for their preparation have found increased interest in the recent past.

Chatani et al, Tetrahedron Letters 24, (1983), 5649-5652 shows a synthesis of (η³-allyl)Co(CO)₃ by reaction of cobalt octacarbonyl Co₂(CO)₃ with trimethylsilane and subsequent reaction with allyl acetate in benzene as a solvent. Chatani indicates the yields for the first stage as 85%, the allyl acetate-related yield of the second stage as 52%. In the optimization of this synthesis, it was found that the cobalt-related overall yield of this process over both stages was not more than 25%.

KR 101587509 describes a synthesis of (η³-allyl)Co(CO)₃ by reaction of cobalt octacarbonyl Co₂(CO)₃ in ethereal solution with aqueous sodium hydroxide in the presence of benzyltriethylammonium chloride as a phase transfer catalyst and subsequent addition of allyl bromide. The organic phase is then separated, dried and the reaction product is purified by distillation after removal of the solvent, wherein the reaction product was obtained in a cobalt-related overall yield of 38% over both stages.

It was the object of the invention to provide a process for the preparation of allyl-cobalt complexes having the general formula [Co(η³-C₃H₄-R1)(CO)₃] or [Co(η³-Allyl-R1)(CO)₃], in particular [Co(η³-C₃H₅)(CO)₃], which allows improved yields.

Surprisingly, it was found, that this task is solved by a process for the preparation of allyl-cobalt complexes having the general formula [Co(η³-C₃H₄-R1)(CO)₃] or [Co(η³-Allyl-R1)(CO)₃] comprising the steps of
a. reaction of cobalt octacarbonyl Co₂(CO)₃ with a trialkylhydrosilane of formula (R2)₃Si-H to a cobalt complex of general formula [(R2)₃Si-Co(CO)₄];
b. reacting the resulting cobalt complex having the general formula [(R2)₃Si-Co(CO)₄] with an organic ester having the general formula R3-(CO₂-allyl-R1)ₓ where X = 1, 2 or 3 to form the cobalt complex [Co(η³-C₃H₄-R1)(CO)₃], wherein R1 and R2 are independently hydrogen or alkyl and R3 is a C3 to C10 alkyl, cycloalkyl or aryl, which may be substituted or condensed with a C1 to C8 alkyl or cycloalkyl, and wherein in step b. a solvent which has a boiling point of more than 200°C at atmospheric pressure is used and wherein this solvent is squalene or the organic ester having the general formula R3-(CO₂-allyl-R1)ₓ.

In an optional step c, the reaction product, i.e. the allyl cobalt complex having general formula [Co(η³-C₃H₄-R1)(CO)₃] or [Co(η³-allyl-R1)(CO)₃], can be removed from the reaction mixture, in particular by distillation. In this case, it is advantageous that no fractional distillation is required and thus a very simple separation of the reaction product is possible.

R1 may in particular denote hydrogen, C1 to C5 alkyl and C1 to C5 cycloalkyl and is in particular selected from the group consisting of H, methyl, ethyl, n-propyl, isopropyl, n-butyl, tert-butyl, cyclobutyl and combinations thereof.

R2 may in this case particularly denote hydrogen and C1 to C5 alkyl and is in particular selected from the group consisting of H, methyl, ethyl, n-propyl, isopropyl, n-butyl and combinations thereof.

R3 is a C3 to C10 alkyl, cycloalkyl or aryl, which may be substituted or condensed with a C1 to C8 alkyl or cycloalkyl. In particular, R3 may be selected from hexyl, heptyl, octyl, cyclohexyl, cyclooctyl, phenyl, 4-toluyl, 2-cyclohexylethyl or combinations thereof.

The organic ester having the general formula R3-(CO₂-allyl-R1)ₓ may be a compound in which x = 1, 2 or 3. In particular, x may be 1 or 2. In particular when R3 is an aromatic or cycloalkyl, x may be 2 or 3, advantageously 2. When R3 is alkyl, then x is advantageously 1. In a specific embodiment, the organic ester having the general formula R3-(CO₂-allyl-R1)ₓ is a heptanoate of the C₆H₁₃CO₂-allyl-R1 type, wherein R1 is as defined above, in particular where R1 = H, methyl, ethyl, isopropyl or tert-butyl.

In step a, it has proven successful when cobalt octacarbonyl Co₂(CO)₃ is added first and the trialkylhydrosilane having formula (R2)₃Si-H is gradually added, wherein good results may be achieved with triethylhydrosilane, i.e. a compound in which R2 is ethyl. Since this is an exothermic reaction, the reaction temperature can also, but not only, be controlled by the rate of addition of the trialkylhydrosilane.

The trialkylhydrosilane can be added first in equimolar ratio relative to the cobalt octacarbonyl Co₂(CO)₃. Good results were obtained with a slight excess of 1.01 to 1.3, in particular 1.02 to 1.2 or 1.04 to 1.1 equivalents of trialkylhydrosilane, in particular triethylhydrosilane. The yields at this stage are usually 95 to 98%.

Suitable solvents are generally branched or unbranched alkanes, ethers or aromatics, in particular those having 5 to 10 carbon atoms. This includes, for example, solvents such as pentane, hexane, heptane, octane, benzene, toluene, diethyl ether, diisopropyl ether, tetrahydrofuran, dioxane or combinations thereof. Good results can be achieved in particular with heptane.

The reaction temperature is generally at room temperature, that is to say about 15°C to 55°C or 20°C to 40°C, in particular 20 to 25°C. The rate of addition and thus also the reaction time therefore depend on the desired reaction temperature. Times of from two to eight, in particular from 3 to 5 or from 2.5 to 4.5 hours, are generally suitable.

Subsequently, the reaction mixture may be maintained at a temperature of from about 15°C to 30°C, more preferably from 20 to 25°C, which may be higher, lower, or equal to the reaction temperature. Stirring can be effected at this temperature for 6 to 24 hours, in particular 8 to 18 hours or 6 to 12 hours. The end of the reaction can easily be detected by the fact that gas evolution no longer occurs.

The solvent and optionally excess silane may thereafter be removed. This can be achieved, for example, by distillation, wherein, if appropriate, a suitable negative pressure can be applied in order to allow distillation at lower temperatures. Usually, a pressure of less than 100 mbar is sufficient in the distillation; pressures in the range from 15 to 70 mbar or 25 to 50 mbar have proven effective. In general, temperatures of 30°C to 70°C, in particular 40°C to 50°C have proven effective.

The temperatures and pressures are evident to the person skilled in the art from the boiling point of the substances to be distilled off and the desired temperature in order to achieve a gentle separation of substances. The thus obtained cobalt complex having the general formula [(R2)₃Si-Co(CO)₄] can then be reacted further in the following process step.

The reaction of the resulting cobalt complex having the general formula [(R2)₃Si-Co(CO)₄] with an organic ester having general formula R3-(CO₂-allyl-R1)ₓ where x = 1, 2 or 3 and wherein R1 and R3 are defined as described above, takes place in step b.

The organic ester having general formula R3-(CO₂-allyl-R1)ₓ is preferably used at least an equimolarly to the cobalt complex having general formula [(R2)₃Si-Co(CO)₄], but can also be used in excess, wherein a 1.1 to double molar excess is sufficient and a still greater excess is harmless.

In the reaction, a solvent having a boiling point of greater than about 200°C at atmospheric pressure is used, which is 2,6,10,15,19,23-hexamethyltetracosane (squalane) or the organic ester having the general formula R3-(CO₂-allyl-R1)ₓ. In particular, the heptanoate of the C₆H₁₃CO₂-allyl-R1 type has proven successful, in particular R1 can denote C1 to C5-alkyl and is in particular selected from the group consisting of H, methyl, ethyl, n-propyl, isopropyl, n-butyl, tert-butyl and combinations thereof.

In principle, the sequence of addition of the reactants, of the cobalt complex having the general formula [(R2)₃Si-Co(CO)₄] and the organic ester of general formula R3-(CO₂-allyl-R1)ₓ, is not critical. It has proven successful to add the cobalt complex first, optionally adding the solvent and, after a possible stirring time, to gradually add the organic ester once the cobalt complex has dissolved or a homogeneous suspension has formed. The reaction temperature is about 20°C to 90°C, in particular 40°C to 80°C or 60°C to 80°C. Good results can be obtained at 65°C to 75°C. Since the reaction is exothermic, the heating can be effected by adding the ester having the general formula R3-(CO₂-allyl-R1)ₓ, although the carrying out of the process can be accelerated by preheating to the reaction temperature. The rate of addition may then be selected such that the reaction temperature does not vary excessively, for example by no more than ±5°C, or the temperature is maintained substantially constant by heating. If the addition is concluded, the reaction temperature can be maintained with stirring to complete the reaction, wherein generally not more than 1 to 8 hours, in particular 1.5 to 5 or 2 to 4 hours, suffice. The end of the reaction can easily be detected by the fact that gas evolution no longer occurs. In this step, since the desired reaction product is the lightest volatile compound, it is simply distilled off. In general, distillation temperatures of 60°C to 100°C at a pressure of less than 25 mbar have proven successful. Good results can be achieved at temperatures of from 60°C to 80°C. and a pressure of less than 10 bar, wherein, if appropriate, the pressure can be lowered successively at a constant temperature. The condenser may be cooled to temperatures of less than 60 °C, such as from 15°C to 50°C, or from 20°C to 45°C.

The process for the preparation of allyl-cobalt complexes having the general formula [Co(η³-C₃H₄-R1)(CO)_{3]} or [Co(η³-allyl-R1)(CO)₃] can also be carried out as a single pot reaction. To this end, after completion of step a, the solvent and excess trialkylhydrosilane may be distilled off, and thereafter the solvent of step b and the organic ester having the general formula R3-(CO₂-allyl-R1)ₓ may be added.

In a simplified configuration of this embodiment, the distillation of the solvent and excess trialkylhydrosilane is dispensed with and the organic ester having the general formula R3-(CO₂-allyl-R1)ₓ and optionally the solvent are added instead. It is advantageous in general, but particularly in this process, if the organic ester having the general formula R3-(CO₂-allyl-R1)ₓ is used as solvent. Since after step b has been carried out excess trialkylhydrosilane and the solvent from step 1 are still present in the reaction mixture in this process variant, fractional distillation is necessary depending on the boiling point of the end product. On the other hand, upon isolation of the product from step a, or at least after removal of solvent and trialkylhydrosilane following completion of step a, fractional distillation following completion of step a can often be dispensed with and the end product recovered by simple distillation.

### Examples

### Example 1 - Step a.: Reaction of dicobalt octacarbonyl with triethylsilane to triethylsilyl cobalt tetracarbonyl

In a 4 liter 4 neck glass flask equipped with a KPG stirrer, a temperature sensor for controlling the internal temperature, a dropping funnel without gas compensation and an intensive cooler with a pressure relief valve, 638 g of dicobalt octacarbonyl (1.86 mol, 1.00 eq.) are introduced and slurried with 1.00 liter of heptane. The reaction flask is maintained at 20 ± 4°C by means of a water bath. The reaction mixture is stirred at 300 rpm. This is followed by dropwise addition of 467 g of triethylsilane (4.02 mol, 2.15 eq.) over the course of four hours, in which case it is ensured that the internal temperature is in the range of 20 ± 4°C. After the end of the addition, the triethylsilane container is rinsed with 100 mL of heptane and the heptane/triethylsilane mixture is added to the reaction mixture. The reaction mixture is stirred at room temperature overnight. The next day, the heptane solvent and excess triethylsilane are distilled off from the reaction mixture at 50°C internal temperature and a pressure of 30 mbar. When the distillate stream begins to run dry, the pressure is successively reduced to a final pressure of 18 mbar. The product remains in the reaction flask. Isolated: 1095 g.

The product can be subjected to a purification step:
For this purpose, the product is condensed in dynamic vacuum. The internal temperature is 50°C, the condenser is cooled with 0°C, and the vacuum is < 1 * 10⁻³ mbar. 573 g of crude product thus yield 534 g of purified material.

### Example 2 - Step b.: Reaction of triethylsilyl cobalt tetracarbonyl with allyl heptanoate to [Co(η³-C₃H₅)(CO)₃]

400 g of purified triethylsilyl cobalt tetracarbonyl (1.40 mol, 1.00 eq.) is introduced into a 4 liter 4-neck glass flask equipped with magnetic stirring core, an intensive cooler with a pressure relief valve, a dropping funnel without gas compensation, a temperature sensor for controlling the internal temperature and a distillation column in combination with a distillation bridge and a condenser. The system can be rendered inert and also evacuated via the condenser. The intensive cooler and the distillation bridge are cooled to -10°C. For the first part of the reaction, the released gas is discharged via the intensive cooler with pressure relief valve. The reaction mixture is stirred at 300 rpm, heated to 70°C internal temperature, and at this temperature 263 g of allyl heptanoate (1.54 mol, 1.10 eq.) are added dropwise. This takes place within 70 minutes, in which case the dropping rate is adjusted in such a way that the internal temperature remains at 70 ± 5°C. After the end of the addition, the reaction mixture is stirred for a further three hours at 70°C until no further evolution of gas is observed. The second part of the reaction consists of distillation of the crude product. The condenser is cooled to about -40°C and, with stirring at 300 rpm, vacuum is slowly applied to the apparatus via the condenser at a sump temperature of 70°C. At a pressure of 29 mbar, the product begins to distill. When the distillate stream tends to sediment, the pressure is successively reduced to 7 mbar. This yields 236 g of the crude product (1.29 mol, 92%) with a purity of 99 m%.

The crude product can be purified by fine distillation:
Distillation at an internal temperature of 40°C and a pressure of 10 mbar via a Vigreux column yields 92% of a product which has a purity of >99 m% of [Co(η³-C₃H₅)(CO)₃].

### Example 3 - Step b.: Reaction of triethylsilyl cobalt tetracarbonyl with diallyl phthalate to [Co(η³-C₃H₅)(CO)₃].

100 g of purified triethylsilyl cobalt tetracarbonyl (0.35 mol, 1.00 eq.) were introduced into a 500 ml 4-neck glass flask equipped with magnetic stirring core, an intensive cooler with a pressure relief valve, a dropping funnel with gas compensation, a temperature sensor for controlling the internal temperature and a distillation bridge with a receiver. The system may be evacuated and inertized. The distillation bridge was cooled to -25°C. The triethylsilyl cobalt tetracarbonyl was stirred at 300 rpm, heated to 70°C internal temperature and at this temperature 47.8 g of diallyl phthalate (0.19 mol, 0.55 eq.) were added dropwise. This addition was taking place within 70 minutes and the dropping rate was adapted in such a way that the internal temperature was at 70±5°C. After the addition, the reaction mixture was further stirred at 70°C internal temperature for three more hours until no more gas evolution could be observed.

The second part of the reaction was consisting of the distillation of the raw product. The receiver was cooled to about -40°C and while stirring the reaction mixture at 300 rpm at a temperature of 70°C, the apparatus was slowly evacuated via the receiver. At a pressure of 30 millibar the product started to distill. When the flow of distillate was about to run dry, the pressure was further reduced successively to a final pressure of 10 millibar. 60.3 g of raw product (0.33 mol, 94%) with a purity of >99% were obtained.

## Claims

1. A method for the preparation of allyl-cobalt complexes having the general formula [Co(η³-C₃H₄-R1)(CO)₃] or [Co(η³-allyl-R1)(CO)₃] comprising the steps of
a. reacting cobalt octacarbonyl Co₂(CO)₃ with a trialkylhydrosilane of the form (R2)₃Si-H to a cobalt complex having the general formula [(R2)₃Si-Co(CO)₄];
b. reacting the resulting cobalt complex having the general formula [(R2)₃Si-Co(CO)₄] with an organic ester having the general formula R3-(CO₂-Allyl-R1)ₓ where X = 1, 2 or 3, to cobalt complex [Co(η³-C₃H₄-R1)(CO)₃], wherein R1 and R2 are independently hydrogen or alkyl and R3 is a C3 to C10 alkyl, cycloalkyl or aryl, which may be substituted or condensed with a C1 to C8 alkyl or cycloalkyl, and wherein in step b. a solvent which has a boiling point of more than 200°C at atmospheric pressure is used and wherein this solvent is squalene or the organic ester having the general formula R3-(CO₂-allyl-R1)ₓ.

2. The method according to claim 1, wherein R1 is selected from the group consisting of H, methyl, ethyl, n-propyl, isopropyl, n-butyl, tert-butyl, cyclobutyl and combinations thereof.

3. The method according to claim 1 or 2, wherein R2 is selected from the group consisting of H, methyl, ethyl, n-propyl, isopropyl, n-butyl, and combinations thereof.

4. The method according to one or more of the preceding claims, wherein R3 is selected from hexyl, heptyl, octyl, cyclohexyl, cyclooctyl, phenyl, 2-cyclohexylethyl or combinations thereof.

5. The method according to one or more of the preceding claims, wherein the organic ester having the general formula R3-(CO₂-allyl-R1)ₓ is a heptanoate of the C₆H₁₃CO₂-allyl-R1 type.

6. The method according to one or more of the preceding claims, wherein the reaction temperature in step a is between 20°C and 55°C, or between 25°C and 30°C.

7. The method according to one or more of the preceding claims, wherein in step a branched or unbranched alkanes, ethers or aromatics having 5 to 10 carbon atoms are used as the solvent.

8. The method according to one or more of the preceding claims, wherein the solvent used in step a. is pentane, hexane, heptane, octane, benzene, toluene, diethyl ether, diisopropyl ether, tetrahydrofuran, dioxane or combinations thereof.

9. The method according to one or more of the preceding claims, wherein the cobalt complex [Co(η³-C₃H₄-R1)(CO)₃] is produced in a single pot method.

10. The method according to one or more of the preceding claims, wherein the cobalt complex [Co(η³-C₃H₄-R1)(CO)₃] is produced in a single pot method, a solvent is used in step a and this is removed before carrying out step b.

11. The method according to one or more of the preceding claims, wherein in a step c the cobalt complex [Co(η³-C₃H₄-R1)(CO)₃] is removed from the reaction mixture.

12. The method according to one or more of the preceding claims, wherein in a step c the cobalt complex [Co(η³-C₃H₄-R1)(CO)₃] is removed from the reaction mixture by distillation.

13. A method for the vapor deposition of cobalt-containing layers comprising the steps of
- providing allyl-cobalt complexes having the general formula [Co(η³-C₃H₄-R1)(CO)₃] or [Co(η³-allyl-R1)(CO)₃] according to one or more of the preceding claims;
- employing the allyl-cobalt complexes having the general formula [Co(η³-C₃H₄-R1)(CO)₃] or [Co(η³-allyl-R1)(CO)₃] in a method for vapor deposition of cobalt-containing layers.

14. The method according to claim 13, wherein the deposition is by thermal decomposition.

15. The method according to claim 13 or 14, wherein said method is an ALD (Atomic Layer Deposition) or CVD (Chemical Vapor Deposition) method.

## Patentansprüche

1. Verfahren zur Herstellung von Allyl-Cobalt-Komplexen mit der allgemeinen Formel [Co(η³-C₃H₄-R1)(CO)₃] oder [Co(η³-Allyl-R1)(CO)₃], umfassend die Schritte
a. Umsetzen von Kobaltoctacarbonyl Co₂(CO)₈ mit einem Trialkylhydrosilan der Form (R2)₃Si-H zu einem Kobaltkomplex mit der allgemeinen Formel [(R2)₃Si-Co(CO)₄];
b. Umsetzen des resultierenden Kobaltkomplexes mit der allgemeinen Formel [(R2)₃Si-Co(CO)₄] mit einem organischen Ester mit der allgemeinen Formel R3-(CO₂-Allyl-R1)ₓ worin X = 1, 2 oder 3 ist, zum Kobaltkomplex [Co(η³-C₃H₄ - R1)(CO)₃], worin R1 und R2 unabhängig voneinander Wasserstoff oder Alkyl sind und R3 ein C3- bis C10-Alkyl, Cycloalkyl oder Aryl ist, das substituiert oder kondensiert sein kann mit einem C1- bis C8-Alkyl oder Cycloalkyl, und worin in Schritt b. ein Lösungsmittel verwendet wird, das einen Siedepunkt von mehr als 200°C bei Atmosphärendruck hat, und wobei dieses Lösungsmittel Squalen oder der organische Ester mit der allgemeinen Formel R3-(CO₂-allyl-R1)ₓ ist.

2. Verfahren nach Anspruch 1, wobei R1 ausgewählt ist aus der Gruppe bestehend aus H, Methyl, Ethyl, n-Propyl, Isopropyl, n-Butyl, tert-Butyl, Cyclobutyl und Kombinationen davon.

3. Verfahren nach Anspruch 1 oder 2, wobei R2 ausgewählt ist aus der Gruppe bestehend aus H, Methyl, Ethyl, n-Propyl, Isopropyl, n-Butyl und Kombinationen davon.

4. Verfahren nach einem oder mehreren der vorhergehenden Ansprüche, wobei R3 ausgewählt ist aus Hexyl, Heptyl, Octyl, Cyclohexyl, Cyclooctyl, Phenyl, 2-Cyclohexylethyl oder Kombinationen davon.

5. Verfahren nach einem oder mehreren der vorhergehenden Ansprüche, wobei der organische Ester mit der allgemeinen Formel R3-(CO₂-allyl-R1)ₓ ein Heptanoat vom Typ C₆H₁₃CO₂-allyl-R1 ist.

6. Verfahren nach einem oder mehreren der vorhergehenden Ansprüche, wobei die Reaktionstemperatur in Schritt a zwischen 20°C und 55°C oder zwischen 25°C und 30°C liegt.

7. Verfahren nach einem oder mehreren der vorhergehenden Ansprüche, **dadurch gekennzeichnet, dass** in Schritt a. verzweigte oder unverzweigte Alkane, Ether oder Aromaten mit 5 bis 10 Kohlenstoffatomen als Lösemittel verwendet werden.

8. Verfahren nach einem oder mehreren der vorhergehenden Ansprüche, wobei das in Schritt a. verwendete Lösemittel Pentan, Hexan, Heptan, Oktan, Benzol, Toluol, Diethylether, Diisopropylether, Tetrahydrofuran, Dioxan oder deren Kombinationen ist.

9. Verfahren nach einem oder mehreren der vorhergehenden Ansprüche, wobei der Kobaltkomplex [Co(η³-C₃H₄-R1)(CO)₃] in einem Eintopfverfahren hergestellt wird.

10. Verfahren nach einem oder mehreren der vorhergehenden Ansprüche, **dadurch gekennzeichnet, dass** der Kobaltkomplex [Co(η³-C₃H₄-R1)(CO)₃] in einem Eintopfverfahren hergestellt wird, in Schritt a ein Lösungsmittel verwendet wird und dieses vor der Durchführung von Schritt b entfernt wird.

11. Verfahren nach einem oder mehreren der vorhergehenden Ansprüche, wobei in einem Schritt c der Kobaltkomplex [Co(η³-C₃H₄-R1)(CO)₃] aus dem Reaktionsgemisch entfernt wird.

12. Verfahren nach einem oder mehreren der vorhergehenden Ansprüche, wobei in einem Schritt c der Kobaltkomplex [Co(η³-C₃H₄-R1)(CO)₃] durch Destillation aus dem Reaktionsgemisch entfernt wird.

13. Verfahren zum Aufdampfen von kobalthaltigen Schichten, das die folgenden Schritte umfasst
- Lieferungen von Allyl-Cobalt-Komplexen mit der allgemeinen Formel [Co(η³-C₃H₄-R1)(CO)₃] oder [Co(η³-allyl-R1)(CO)₃] nach einem oder mehreren der vorhergehenden Ansprüche;
- Einsatz der Allyl-Cobalt-Komplexe mit der allgemeinen Formel [Co(η³-C₃H₄R1)(CO)₃] oder [Co(η³-allyl-R1)(CO)₃] in einem Verfahren zur Aufdampfung von kobalthaltigen Schichten.

14. Verfahren nach Anspruch 13, wobei die Abscheidung durch thermische Zersetzung erfolgt.

15. Verfahren nach Anspruch 13 oder 14, wobei das Verfahren ein ALD- (Atomic Layer Deposition) oder CVD- (Chemical Vapor Deposition) Verfahren ist.

## Revendications

1. Procédé de préparation de complexes allyle-cobalt de formule générale [Co(η³ - C₃H₄-R1)(CO)₃] ou [Co(η³-allyl-R1)(CO)₃] comprenant les étapes suivantes
a. en faisant réagir l'octacarbonyle de cobalt Co₂(CO)₈ avec un trialkylhydrosilane de la forme (R2)₃Si-H en un complexe de cobalt ayant la formule générale [(R2)₃Si-Co(CO)]₄;
b. réaction du complexe de cobalt résultant ayant la formule générale [(R2)₃Si-Co(CO)₄] avec un ester organique ayant la formule générale R3-(CO₂-Allyl-R1)ₓ où X = 1, 2 ou 3, pour obtenir le complexe de cobalt [Co(η³-C₃H₄-R1)(CO)₃], dans lequel R1 et R2 sont indépendamment des atomes d'hydrogène ou d'alkyle et R3 est un alkyle ou un cycloalkyle en C3 à C10, qui peut être substitué ou condensé avec un alkyle ou un cycloalkyle en C1 à C8, ou un cycloalkyle en C1 à C8, dans lequel R1 et R2 sont indépendamment un hydrogène ou un alkyle et R3 est un alkyle en C3 à C10, un cycloalkyle ou un aryle, qui peut être substitué ou condensé avec un alkyle en C1 à C8 ou un cycloalkyle, et dans lequel, à l'étape b. on utilise un solvant dont le point d'ébullition est supérieur à 200°C à la pression atmosphérique et dans lequel ce solvant est le squalène ou l'ester organique répondant à la formule générale R3-(CO₂ -allyl-R1)ₓ.

2. Procédé selon la revendication 1, dans laquelle R1 est choisi dans le groupe constitué de H, méthyl, éthyl, n-propyl, isopropyl, n-butyl, tert-butyl, cyclobutyl et leurs combinaisons.

3. Procédé selon la revendication 1 ou 2, dans laquelle R2 est choisi dans le groupe constitué de H, méthyl, éthyl, n-propyl, isopropyl, n-butyl, et leurs combinaisons.

4. Procédé selon l'une ou plusieurs des revendications précédentes, dans laquelle R3 est choisi parmi les hexyles, les heptyles, les octyles, les cyclohexyles, les cyclooctyles, les phényles, les 2-cyclohexyléthyles ou des combinaisons de ceux-ci.

5. Procédé selon une ou plusieurs des revendications précédentes, dans lequel l'ester organique de formule générale R3-(CO₂-allyl-R1)ₓ est un heptanoate du type C₆H₁₃CO₂-allyl-R1.

6. . Procédé selon l'une ou plusieurs des revendications précédentes, dans laquelle la température de réaction à l'étape a est comprise entre 20°C et 55°C, ou entre 25°C et 30°C.

7. Procédé selon l'une ou plusieurs des revendications précédentes, dans lequel, à l'étape a, on utilise comme solvant des alcanes, des éthers ou des aromatiques ramifiés ou non, ayant de 5 à 10 atomes de carbone.

8. Procédé selon une ou plusieurs des revendications précédentes, dans lequel le solvant utilisé à l'étape a. est le pentane, l'hexane, l'heptane, l'octane, le benzène, le toluène, l'éther diéthylique, l'éther diisopropylique, le tétrahydrofurane, le dioxane ou des combinaisons de ceux-ci.

9. Procédé selon une ou plusieurs des revendications précédentes, dans laquelle le complexe de cobalt [Co(η³-C₃H₄ -R1)(CO)₃] est produit par une méthode à pot unique.

10. . Procédé selon une ou plusieurs des revendications précédentes, dans laquelle le complexe de cobalt [Co(η³-C₃H₄-R1)(CO)₃] est produit par une méthode à pot unique, un solvant est utilisé à l'étape a et il est éliminé avant l'étape b.

11. . La Procédé selon une ou plusieurs des revendications précédentes, dans laquelle, à l'étape c, le complexe de cobalt [Co(η³ -C₃H₄-R1)(CO)₃] est éliminé du mélange réactionnel.

12. . La Procédé selon l'une ou plusieurs des revendications précédentes, dans laquelle, à l'étape c, le complexe de cobalt [Co(η³-C₃H₄-R1)(CO)₃] est éliminé du mélange réactionnel par distillation.

13. Procédé de dépôt en phase vapeur de couches contenant du cobalt, comprenant les étapes suivantes
- fournir des complexes allyl-cobalt de formule générale [Co(η³-C₃H₄-R1)(CO)₃] ou [Co(η³-allyl-R1)(CO)₃] selon une ou plusieurs des revendications précédentes;
- utiliser les complexes allyle-cobalt de formule générale [Co(η³-C3H₄-R1)(CO)₃] ou [Co(η³-allyl-R1)(CO)₃] dans une méthode de dépôt en phase vapeur de couches contenant du cobalt.

14. . Procédé selon la revendication 13, dans laquelle le dépôt se fait par décomposition thermique.

15. . Procédé selon la revendication 13 ou 14, dans laquelle ladite méthode est une méthode ALD (Atomic Layer Deposition) ou CVD (Chemical Vapor Déposition).
